(19) Europäisches Patentamt
European Patent Office
Office européen des brevets

(11) EP 3 072 941 A1

(12) DEMANDE DE BREVET EUROPEEN

(43) Date de publication:
**28.09.2016 Bulletin 2016/39**

(21) Numéro de dépôt: **16161548.9**

(22) Date de dépôt: **22.03.2016**

(51) Int Cl.:
***C09K 11/02*** *(2006.01)* ***C09K 11/62*** *(2006.01)*
***C09K 11/58*** *(2006.01)*

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD**

(30) Priorité: **23.03.2015 FR 1552400**

(71) Demandeur: **COMMISSARIAT A L'ENERGIE ATOMIQUE ET AUX ENERGIES ALTERNATIVES**
**75015 Paris (FR)**

(72) Inventeurs:
- **CHEVALLIER, Théo**
**38000 Grenoble (FR)**
- **CHANDEZON, Frédéric**
**38430 Moirans (FR)**
- **LE BLEVENNEC, Gilles**
**38190 Bernin (FR)**

(74) Mandataire: **Nony**
**11 rue Saint-Georges**
**75009 Paris (FR)**

(54) **PROCÉDÉ POUR AUGMENTER LE RENDEMENT QUANTIQUE INTERNE DE PHOTOLUMINESCENCE DE NANOCRISTAUX, EN PARTICULIER DE NANOCRISTAUX D'AGINS2-ZNS**

(57) La présente invention concerne un procédé pour augmenter le rendement quantique interne de photoluminescence de nanoparticules formées en tout ou partie d'un nanocristal de type $Ag_xM_yM'_zS_{0.5x+y+1,5z}$ (I), comprenant au moins les étapes consistant en :
(1) disposer de nanoparticules formées en tout ou partie d'un nanocristal dont la composition chimique répond à la formule (I) :

$$Ag_xM_yM'_zS_{0.5x+y+1.5z} \quad (I)$$

lesdites nanoparticules étant fonctionnalisées en surface par un ligand organique L1 différent d'un ligand de type phosphine ;
lesdits nanocristaux de composition chimique de formule (I) étant préalablement préparés *via* un procédé mettant en oeuvre une unique étape de traitement thermique ;
et
(2) mettre en présence lesdites nanoparticules avec au moins un composé ligand L2 de type phosphine de formule générale $PR_3$ (II), ou sa forme oxydée $O=PR_3$ (II'), dans des conditions propices à un échange, au moins en partie, des ligands organiques L1 par lesdits ligands de type phosphine L2.

EP 3 072 941 A1

## Description

La présente invention vise à proposer une nouvelle méthode permettant d'augmenter l'efficacité de photoluminescence de particules semi-conductrices à base de nanocristaux tels que ceux formés de solutions solides de type $AgInS_2$-ZnS (plus connues sous l'appellation « ZAIS »).

D'une manière générale, la photoluminescence consiste à convertir les photons d'une certaine longueur d'onde en photons de longueur d'onde différente, en général de plus basse énergie. Dans un premier temps, les photons d'excitation sont absorbés par le matériau. Dans un second temps, l'énergie absorbée peut être en partie restituée sous la forme de photons de longueur d'onde correspondant à la différence d'énergie des niveaux électroniques mis en jeu lors de la désexcitation du matériau. Les pertes occasionnées lors de ce processus sont liées aux phénomènes dits « non radiatifs » de recombinaison des porteurs, en général facilités par la présence de défauts dans le matériau.

Le rendement quantique interne (RQI) est la mesure absolue du ratio entre le nombre total de photons émis par le matériau et le nombre total de photons absorbés. Un RQI de 100 % indique ainsi que chaque photon absorbé a donné lieu à un photon émis, sans pertes causées par les phénomènes non radiatifs. Le RQI est donc une mesure universelle de l'efficacité du processus de luminescence d'un matériau, quel que soit son type (molécule, particule semi-conductrice, oxyde dopé terres rares, etc.).

Cependant, l'efficacité globale d'un matériau luminescent est également liée à sa capacité à absorber la lumière excitatrice. Les matériaux utilisés commercialement dans le domaine des diodes électroluminescentes (LED) blanches sont des oxydes dopés terres-rares, typiquement du YAG :Ce (acronyme de l'anglais « Yttrium Aluminium Garnet » désignant le « grenat d'yttrium et d'aluminium » dopé au cérium (Ce)), qui présentent de très bons rendements quantiques internes, mais des absorptions faibles.

D'un autre côté, les nanocristaux de semi-conducteurs présentent une absorption massique environ 1000 fois plus grande mais des rendements quantiques internes plus faibles.

La présente invention vise précisément à augmenter le rendement quantique de photoluminescence de nanocristaux semi-conducteurs de composition chimique $Ag_xM_yM'_zS_{0,5x+y+1,5z}$ (avec M représentant Zn, Cd, Hg ou leurs mélanges ; M' représentant Al, Ga, In, T1 ou leurs mélanges ; $0 < x \leq 1$ ; $0 \leq y \leq 1$ et $0 < z \leq 1$), comme par exemple des nanocristaux formés de solutions solides de type $Ag_xZn_yIn_zS_{0,5x+y+1,5z}$ (plus généralement appelées « solutions solides $AgInS_2$-ZnS », ou plus simplement « ZAIS »), afin de tirer profit de la forte absorption intrinsèque de ces matériaux.

Les nanocristaux de type ZAIS sont connus pour leur propriété de photoluminescence dans une large gamme du spectre de la lumière visible, selon leur composition chimique. La synthèse en voie liquide et l'utilisation des nanocristaux de ZAIS ont déjà été développées par Torimito *et al.* ([1]) et Park Joung *et al.* ([2], [3]). La structure de ces matériaux est celle d'une solution solide semblable à la phase cubique de ZnS dont les sites du zinc sont aléatoirement occupés par l'argent, l'indium ou le zinc, dans des proportions variables. La composition exacte du matériau détermine les niveaux d'énergie mis en jeu et donc la photoluminescence qui en découle ainsi que le rendement quantique qui y est associé. Ces matériaux présentent une bande d'émission large (environ 150 nm) et peuvent être utilisés comme traceurs en biologie ou comme matériaux émetteurs dans une diode électroluminescente. En particulier, la largeur d'émission, la forte absorption, le faible coût et la non-toxicité des nanocristaux de ZAIS en font un matériau de choix pour une application comme luminophore dans une LED blanche.

Pour augmenter le rendement quantique de ces matériaux, il a déjà été proposé de mettre en oeuvre une étape de recuit supplémentaire et de former une coquille de ZnS protectrice à la surface des nanocristaux ([4]). Des rendements quantiques améliorés, allant de 20 % (vert) à 80 % (rouge), peuvent ainsi être obtenus avec des nanocristaux de ZAIS enrobés d'une coquille de ZnS, tandis que les rendements quantiques pour des nanocristaux sans coquille vont de 15 % (vert) à 66 % (rouge).

La présente invention vise à proposer un nouveau procédé permettant d'accroître encore le rendement quantique interne de photoluminescence (RQI) des nanocristaux de composition chimique de type $Ag_xM_yM'_zS_{0,5x+y+1,5z}$, et notamment des nanocristaux ZAIS, en particulier en vue de leur utilisation comme luminophore dans une diode électroluminescente blanche.

Ainsi, selon un premier de ses aspects, la présente invention concerne un procédé pour augmenter le rendement quantique interne de photoluminescence de nanoparticules formées au moins en partie d'un nanocristal de type $Ag_xM_yM'_zS_{0,5x+y+1,5z}$, comprenant au moins les étapes consistant en :

(1) disposer de nanoparticules formées en tout ou partie d'un nanocristal dont la composition chimique répond à la formule (I) :

$$Ag_xM_yM'_zS_{0,5x+y+1,5z} \qquad (I)$$

dans laquelle :

M est choisi parmi le zinc, le cadmium, le mercure et leurs mélanges ;
M' est choisi parmi l'aluminium, le gallium, l'indium, le thallium et leurs mélanges ;

$$0 < x \leq 1 \ ; 0 \leq y \leq 1 \text{ et } 0 < z \leq 1 \ ;$$

lesdites nanoparticules étant fonctionnalisées en surface par au moins un ligand organique L1 différent d'un ligand de type phosphine ; et

(2) mettre en présence lesdites nanoparticules avec au moins un composé ligand L2 de type phosphine de formule générale :

$PR_3$ (II),

ou sa forme oxydée

$O=PR_3$ (II'),

chacun des groupes R, identiques ou différents, étant choisi parmi l'hydrogène, un groupe alkyle et un groupe cycloalkyle, lesdits groupes alkyle et cycloalkyle étant éventuellement substitués ;

dans des conditions propices à un échange, au moins en partie, des ligands organiques L1 par lesdits ligands de type phosphine L2.

Dans la suite du texte, on désignera plus simplement sous l'appellation « nanocristaux de composition (I) », les nanocristaux dont la composition chimique répond à la formule (I) précitée.

Selon une variante de réalisation, les nanoparticules considérées selon l'invention sont formées en tout ou partie d'un nanocristal constitué d'une solution solide de type $AgInS_2$-ZnS, désigné dans la suite du texte « nanocristal de ZAIS ». Autrement dit, dans le cadre de cette variante, la composition chimique du nanocristal répond à la formule (I) précitée dans laquelle M représente le zinc, M' représente l'indium et $0 < x, y, z \leq 1$.

Les inventeurs ont ainsi découvert qu'il est possible d'augmenter significativement le rendement quantique interne (RQI) de photoluminescence des nanocristaux semi-conducteurs de composition (I) considérés selon l'invention, tels que des nanocristaux de ZAIS, en les fonctionnalisant par des ligands spécifiques de type phosphine, telle que la trioctylphosphine (TOP).

L'utilisation de trioctylphosphine (TOP) ou d'oxyde de trioctylphosphine (TOPO) pour des nanocristaux semi-conducteurs est courante dans le domaine de la synthèse des « quantum dots ». Ces ligands y sont utilisés dans le but de contrôler la taille des cristallites synthétisées. De fait, dans le cas où la particule de semi-conducteur atteint une taille suffisamment petite, le phénomène de confinement quantique a pour effet d'augmenter la différence d'énergie entre les niveaux qui produisent la luminescence et ainsi de modifier la longueur d'onde émise. En revanche, le confinement quantique n'a pas d'effet sur le rendement quantique de luminescence. Qui plus est, d'une manière générale, la taille des nanocristaux de ZAIS est plus élevée que la taille critique en-dessous de laquelle le phénomène de confinement quantique entre en jeu. Par conséquent, la trioctylphosphine et son oxyde ne sont pas, d'une manière générale, utilisés comme ligands de synthèse de nanocristaux de type ZAIS.

On peut noter que Mao *et al.* [5] mettent en oeuvre la TOP lors de la synthèse de nanocristaux de ZAIS. Aucune information n'est toutefois donnée quant à l'état de surface des nanocristaux résultant de la synthèse décrite qui conduit, d'ailleurs, à des rendements quantiques faibles.

Enfin, dans le cadre de l'utilisation de ligands de fonctionnalisation en surface de nanocristaux de semi-conducteurs, il a été montré qu'un échange des ligands phosphine par des ligands amine à la surface de quantum dots à base de CdSe permet d'exacerber l'émission provenant des défauts intrinsèquement présents dans la structure ([6]).

Toutefois, à la connaissance des inventeurs, l'utilisation de ligands de type phosphine n'a jamais été proposée pour accroître le rendement quantique interne de photoluminescence des nanocristaux de composition (I) considérés selon l'invention, en particulier des nanocristaux préparés selon le nouveau procédé détaillé ci-après, notamment des nanocristaux de ZAIS.

La mise en oeuvre du procédé de fonctionnalisation des nanocristaux selon l'invention, par exemple des nanocristaux de ZAIS, s'avère particulièrement avantageuse, notamment pour leur utilisation comme luminophore dans une diode électroluminescente blanche.

Comme illustré dans les exemples qui suivent, la fonctionnalisation des nanocristaux de composition (I) selon l'invention, à l'exemple des nanocristaux de ZAIS, par un ligand de type phosphine selon l'invention, par exemple la trioctylphosphine, permet d'accéder à des rendements quantiques significativement améliorés.

L'invention concerne ainsi, selon un autre de ses aspects, l'utilisation d'un composé de type phosphine de formule $PR_3$ (II) ou sa forme oxydée $O=PR_3$ (II'), R étant tel que défini que défini précédemment, à titre de ligand de fonctionnalisation de nanoparticules formées en tout ou partie d'un nanocristal dont la composition chimique répond à la formule (I) précitée, pour améliorer leur rendement quantique interne de photoluminescence.

De manière avantageuse, l'amélioration des performances de photoluminescence des nanoparticules fonctionnalisées en surface selon l'invention apparaît quel que soit le solvant (chloroforme ou toluène par exemple) ou le polymère (polyméthacrylate (PMMA) ou polystyrène par exemple) dans lequel les nanoparticules fonctionnalisées sont dispersées.

Par ailleurs, comme détaillé dans la suite du texte, cette fonctionnalisation en surface des nanoparticules selon l'invention peut être combinée avec la mise en oeuvre d'une coquille de ZnS, permettant ainsi d'accéder à des rendements quantiques de photoluminescence optimisés.

Enfin, les inventeurs ont développé un nouveau procédé de synthèse des nanocristaux de composition (I) considérés selon l'invention, par exemple des nanocristaux de ZAIS, mettant en oeuvre une unique étape de chauffage du précurseur dispersé dans le ligand organique L1 (par exemple une amine telle que l'oleylamine), et permettant, de manière surprenante, d'accroître encore le rendement quantique de photoluminescence des nanoparticules fonctionnalisées selon l'invention.

Ainsi, selon un mode de réalisation particulier, l'invention concerne un procédé pour augmenter le rendement quantique interne de photoluminescence de nanoparticules formées au moins en partie d'un nanocristal de type $Ag_x M_y M'_z S_{0,5x+y+1,5z}$, comprenant au moins les étapes consistant en :

(1) disposer de nanoparticules formées en tout ou partie d'un nanocristal dont la composition chimique répond à la formule (I) :

$$Ag_x M_y M'_z S_{0,5x+y+1,5z} \qquad (I)$$

dans laquelle :

M est choisi parmi le zinc, le cadmium, le mercure et leurs mélanges ;
M' est choisi parmi l'aluminium, le gallium, l'indium, le thallium et leurs mélanges ;

$$0 < x \leq 1 \; ; 0 \leq y \leq 1 \text{ et } 0 < z \leq 1 \; ;$$

lesdites nanoparticules étant fonctionnalisées en surface par au moins un ligand organique L1 différent d'un ligand de type phosphine ;
lesdits nanocristaux de composition chimique de formule (I) étant préalablement préparés *via* un procédé comprenant au moins les étapes consistant en :

(a) disposer d'une poudre de précurseur de composition $Ag_x M_y M'_z (S_2CN(C_2H_5)_2)_{x+2y+3z}$, avec M, M', x, y et z étant tels que définis ci-dessus ;
(b) disperser ladite poudre de précurseur dans le ligand organique L1 à l'état liquide ; et
(c) soumettre la dispersion obtenue en étape (b) à un traitement thermique, sous atmosphère inerte, à une température comprise entre 100 °C et 250 °C, pour obtenir lesdits nanocristaux de composition (I),

ledit procédé de préparation des nanocristaux de composition (I) mettant en oeuvre une unique étape de traitement thermique consistant en l'étape (c) ; et
(2) mettre en présence lesdites nanoparticules avec au moins un composé ligand L2 de type phosphine de formule générale :

$$PR_3 \qquad (II),$$

ou sa forme oxydée

$$O{=}PR_3 \qquad (II'),$$

chacun des groupes R, identiques ou différents, étant choisi parmi l'hydrogène, un groupe alkyle et un groupe cycloalkyle, lesdits groupes alkyle et cycloalkyle étant éventuellement substitués ;

dans des conditions propices à un échange, au moins en partie, des ligands organiques L1 par lesdits ligands de type phosphine L2

Outre son influence sur le rendement quantique de luminescence, le procédé modifié de synthèse des nanocristaux considérés selon l'invention, par rapport au protocole de synthèse proposé par Torimoto *et al.* [1], induit un décalage de l'émission par les nanocristaux vers de plus faibles longueurs d'onde (effet « blue-shift »), ce qui est particulièrement intéressant dans le cas de l'application des nanoparticules selon l'invention comme matériau luminophore dans une diode électroluminescente (LED) blanche pour convertir efficacement la lumière bleue en lumière jaune.

D'autres caractéristiques, variantes et avantages du procédé selon l'invention, et de sa mise en oeuvre, ressortiront mieux à la lecture de la description, des exemples et des figures qui suivent, donnés à titre illustratif et non limitatif de l'invention.

Dans la suite du texte, les expressions « compris entre ... et ... », « allant de ... à ... » et « variant de ... à ... » sont équivalentes et entendent signifier que les bornes sont incluses, sauf mention contraire.

Sauf indication contraire, l'expression « comportant/comprenant un(e) » doit être comprise comme « comportant/comprenant au moins un(e) ».

## Etape (1) : NANOPARTICULES FONCTIONNALISEES PAR UN LIGAND ORGANIQUE L1

Comme précisé précédemment, l'étape (1) du procédé de l'invention consiste à disposer de nanoparticules formées en tout ou partie d'un nanocristal préparé selon le nouveau procédé détaillé ci-après et dont la composition chimique répond à la formule (I) :

$$Ag_xM_yM'_zS_{0,5x+y+1,5z} \qquad (I)$$

dans laquelle :

M est choisi parmi le zinc (Zn), le cadmium (Cd), le mercure (Hg) et leurs mélanges ;
M' est choisi parmi l'aluminium (Al), le gallium (Ga), l'indium (In), le thallium (Tl) et leurs mélanges ;

$$0 < x \leq 1 \ ; 0 \leq y \leq 1 \text{ et } 0 < z \leq 1 \ ;$$

lesdites nanoparticules étant fonctionnalisées en surface par au moins un ligand organique, noté L1 dans la suite du texte, différent d'un ligand de type phosphine.

### *Nanoparticules*

Selon un mode de réalisation particulier, M dans la formule (I) précitée représente le zinc.

Selon un autre mode de réalisation particulier, M' dans la formule (I) précitée représente l'indium.

Selon une variante de réalisation, les nanoparticules mises en oeuvre selon l'invention sont formées au moins en partie d'un nanocristal dont la composition chimique répond à la formule (I) précitée, dans laquelle M représente le Zn et M' représente l'indium.

Autrement dit, le nanocristal peut être de composition (I') suivante :

$$Ag_xZn_yIn_zS_{0,5x+y+1,5z} \qquad (I')$$

avec x, y et z étant tels que définis précédemment.

Dans une autre variante de réalisation, M et M', dans la formule (I) précitée, peuvent comprendre des atomes différents respectivement du zinc et de l'indium. Les atomes ou mélanges d'atomes M et M' sont avantageusement choisis afin d'avoir un rayon ionique moyen proche de celui du zinc et de l'indium respectivement. La stabilité de la structure cristalline pourra être d'autant plus assurée par sa capacité à s'adapter, notamment en créant des défauts dans le réseau cristallin.

Selon un mode de réalisation particulier, y dans la formule (I) ou (I') précitée vaut 0. A titre d'exemple, il peut s'agir d'un nanocristal d'$AgInS_2$.

Selon un autre mode de réalisation particulier, y dans la formule (I) ou (I') précitée est différent de 0.

En particulier, selon une variante de réalisation, le nanocristal considéré selon l'invention est constitué d'une solution solide de type $Ag_xZn_yIn_zS_{0,5x+y+1,5z}$ (I'), dans laquelle x, y et z varient entre 0 et 1, x, y et z étant tous différents de zéro.

Ces solutions solides sont plus généralement appelées « solutions solides $AgInS_2$-ZnS » et connues sous l'abréviation « ZAIS ».

Dans le cadre de cette variante de réalisation, x, y et z peuvent être tels que : x = z et y = 2-2x.

Toujours dans le cadre de cette variante de réalisation, x peut varier plus particulièrement entre 0,4 et 1 ; y peut varier plus particulièrement entre plus particulièrement entre 0,1 et 1,2 ; et z peut varier plus particulièrement entre 0,4 et 1.

Plusieurs variantes de nanoparticules sont envisageables. Les nanoparticules peuvent être formées dudit nanocristal, ou présenter une structure coeur/coquille, le coeur étant constitué dudit nanocristal. Dans tous les cas, ledit nanocristal est préparé selon le nouveau procédé détaillé ci-dessous qui met en oeuvre une unique étape de traitement thermique opérée sur la dispersion du précurseur dans le ligand organique L1.

Selon une première variante de réalisation, les nanoparticules sont formées du nanocristal de composition (I) tel que décrit précédemment. A titre d'exemple, les nanoparticules peuvent être des nanocristaux de ZAIS.

Les nanocristaux considérés selon l'invention, par exemple les nanocristaux de ZAIS, peuvent présenter une taille moyenne supérieure ou égale à 3 nm, en particulier comprise entre 3 nm et 12 nm et plus particulièrement comprise entre 5 nm et 8 nm.

La taille moyenne des nanocristaux peut être déterminée par microscopie électronique, en particulier par microscopie électronique à transmission, et plus particulièrement par microscopie électronique à transmission haute résolution (HRTEM) ou microscopie électronique à balayage par transmission (STEM).

Pour de telles tailles de nanocristaux (≥ 3 nm), le phénomène de confinement quantique, connu par exemple pour les nanocristaux semi-conducteurs de type « quantum-dots », n'a pas lieu.

Selon une deuxième variante de réalisation, les nanoparticules peuvent présenter une structure de type coeur/coquille, le coeur étant formé d'un nanocristal de composition (I) tel que décrit précédemment, par exemple d'un nanocristal de ZAIS, et la coquille étant en un composé semi-conducteur.

Le composé semi-conducteur est plus particulièrement un alliage semi-conducteur binaire, ternaire ou quaternaire formé d'au moins un élément du groupe I, II ou III (élément des colonnes I, II ou III de la Classification périodique des éléments) et d'au moins un élément du groupe V ou VI (élément des colonnes V ou VI de la Classification périodique des éléments).

Il peut s'agir par un exemple d'un alliage semi-conducteur choisi parmi ZnS, ZnSe, CdS, AlP, GaP, $Al_2S_3$ et $Ga_2S_3$. En particulier, le composé semi-conducteur peut être ZnS.

Selon un mode de réalisation particulier, les nanoparticules présentent un coeur constitué d'un nanocristal ZAIS recouvert par une coquille de ZnS.

Les nanoparticules de structure coeur/coquille peuvent présenter une taille moyenne comprise entre 3 et 40 nm, en particulier entre 5 et 10 nm.

La coquille des nanoparticules, en particulier en ZnS, peut présenter une épaisseur comprise entre 0,5 et 15 nm, en particulier entre 1 et 3 nm.

*Ligands organique L1 de fonctionnalisation des nanoparticules*

Les nanoparticules mises en oeuvre en étape (1) du procédé selon l'invention sont fonctionnalisées en surface par au moins un ligand organique différent des ligands de type phosphine.

Les ligands organiques L1 peuvent être de nature variée. Ils sont avantageusement choisis parmi les composés présentant un point d'ébullition suffisamment élevé afin de pouvoir servir de solvant pour la synthèse des nanoparticules, comme détaillé dans la suite du texte.

En particulier, le composé ligand L1 peut avantageusement présenter une température d'ébullition supérieure ou égale à 180 °C, en particulier supérieure ou égale à 250 °C et plus particulièrement supérieure ou égale à 365 °C.

Les ligands organiques L1 peuvent être par exemple choisis parmi :

- les amines comprenant au moins une chaîne hydrocarbonée linéaire ou ramifiée, saturée ou insaturée, comportant au moins 8 atomes de carbone ;
- les alcènes comportant au moins 10 atomes de carbone, tel que par exemple l'octadécène ; et
- les thiols comprenant au moins une chaîne hydrocarbonée linéaire ou ramifiée, saturée ou insaturée, comportant au moins 2 atomes de carbone, tel que par exemple le dodécanethiol.

Selon une variante de réalisation, le ligand L1 est choisi parmi les amines, en particulier les amines présentant une chaîne hydrocarbonée linéaire ou ramifiée, saturée ou insaturée, comportant de 8 à 30 atomes de carbone.

En particulier, il peut s'agir d'une amine primaire.

Selon un mode de réalisation particulièrement préféré, le ligand de fonctionnalisation est l'oleylamine.

Préparation des nanoparticules

Comme mentionné précédemment, les nanocristaux considérés en étape 1) selon l'invention, tels que des nanocristaux de ZAIS, sont préalablement préparés *via* un procédé original comprenant au moins les étapes consistant en :

(a) disposer d'une poudre de précurseur de composition $Ag_xM_yM'_z(S_2CN(C_2H_5)_2)_{x+2y+3z}$, avec M, M', x, y et z étant tels que définis précédemment ;
(b) disperser ladite poudre de précurseur dans le ligand organique L1 à l'état liquide ; et
(c) soumettre la dispersion obtenue en étape (b) à un traitement thermique, sous atmosphère inerte, par exemple sous atmosphère d'argon, à une température comprise entre 100 °C et 250 °C, pour obtenir lesdits nanocristaux de composition (I).

Le procédé de préparation des nanocristaux de composition (I) met ainsi en oeuvre une unique étape de traitement thermique consistant en l'étape (c).
Autrement dit, le procédé de préparation des nanocristaux de composition (I) met en oeuvre une unique étape de traitement thermique opérée sur la dispersion du précurseur dans le ligand organique L1 selon l'étape (c).
De fait, les étapes (a) et (b) ne comprennent aucun chauffage du précurseur. En particulier, les étapes (a) et (b) sont réalisées à température ambiante.
Ainsi, dans le procédé de préparation des nanocristaux de composition (I) selon l'invention, le précurseur n'est pas préalablement chauffé avant l'ajout du ligand organique L1.
Selon un mode de réalisation particulier, le procédé de préparation des nanocristaux de composition (I) consiste en les étapes (a) à (c), l'étape (c) étant l'unique étape de traitement thermique dudit procédé.
De manière surprenante, les inventeurs ont montré que la préparation des nanocristaux de composition (I), par exemple des nanocristaux de ZAIS, selon le procédé modifié décrit ci-dessus, ne mettant en oeuvre qu'une unique étape de chauffage du précurseur dispersé dans le ligand organique L1, par exemple dans une amine tel que l'oleylamine, permet, comparativement à la synthèse connue de la publication [1], un décalage de l'émission de photoluminescence des nanocristaux vers de plus faibles longueurs d'onde.
Cet effet est observé quelle que soit la fonctionnalisation de surface des nanocristaux (ligands organiques L1, par exemple de type amine, ou ligands de type phosphine selon l'invention).
Par ailleurs, la préparation des nanocristaux selon le procédé de l'invention rend superflue la mise en oeuvre d'une étape de recuit additionnelle telle que proposée par Torimoto *et al* ([4]).
Ainsi, l'invention se rapporte, d'une manière générale, à un nouveau procédé de préparation de nanocristaux dont la composition chimique répond à la formule (I) précitée, comprenant au moins les étapes consistant en :

- disposer d'une poudre de précurseur de composition $Ag_xM_yM'_z(S_2CN(C_2H_5)_2)_{x+2y+3z}$, avec M, M', x, y et z étant tels que définis précédemment ;
- disperser ladite poudre de précurseur dans un ligand organique L1, en particulier un amine telle que l' oleylamine, à l'état liquide ;
- soumettre la dispersion à un traitement thermique, sous atmosphère inerte, à une température comprise entre 100 °C et 250 °C ; et éventuellement
- récupérer les nanocristaux de composition chimique de formule (I) précitée, fonctionnalisés en surface par le ligand organique L1, formés à l'issue de l'étape de traitement thermique.

Par ailleurs, de manière inattendue, comme illustré en exemple 5, la préparation des nanocristaux considérés selon l'invention, en particulier des nanocristaux de ZAIS, selon ce nouveau procédé permet d'exacerber l'augmentation du rendement quantique interne de photoluminescence, obtenue avec une fonctionnalisation selon l'invention des nanoparticules par des ligands spécifiques de type phosphine.
Selon un mode de réalisation particulier, la poudre de précurseur mise en oeuvre est de composition $Ag_xM_yM'_z(S_2CN(C_2H_5)_2)_{x+2y+3z}$ avec x = z et y = 2-2x, par exemple x et z valant environ 0,9 et y valant environ 0,2, ou encore avec x et z valant environ 0,7 et y valant environ 0,6.
En particulier, dans le cadre de la préparation de nanocristaux de ZAIS, la poudre de précurseur mise en oeuvre peut être de composition $Ag_xZn_yIn_z(S_2CN(C_2H_5)_2)_{x+2y+3z}$, avec x = z et y = 2-2x, par exemple x et z valant environ 0,9 et y valant environ 0,2.
Les nanocristaux de ZAIS, préparés à partir d'une telle composition de précurseur, présentent un rendement quantique de photoluminescence optimal.
La poudre de précurseur de composition $Ag_xM_yM'_z(S_2CN(C_2H_5)_2)_{x+2y+3z}$ peut être préparée préalablement, comme illustré en exemple 1, par précipitation en milieu aqueux du diéthyldithiocarbamate de sodium avec les ions

métalliques sous forme de nitrates $AgNO_3$, $In(NO_3)_3$ et $Zn(NO_3)_2$ dans des proportions adéquates.

Le composé ligand L1, par exemple de type amine, destiné à former les ligands en surface des nanocristaux de ZAIS, mis en oeuvre à l'état liquide en étape (b) sert de solvant pour la synthèse des nanocristaux.

Selon un mode de réalisation particulier, le ligand organique L1 est l'oleylamine.

Selon un mode de réalisation particulier, le traitement thermique en étape (c) est opéré à une température d'environ 180 °C.

La durée du chauffage peut être comprise entre 3 minutes et 4 heures, en particulier entre 5 minutes et 1 heure et plus particulièrement entre 10 et 30 minutes. De préférence, elle est comprise entre 20 et 30 minutes.

Le traitement thermique peut être par exemple opéré sous atmosphère d'argon.

Les nanoparticules sont préparées à partir des nanocristaux de composition (I) formés à l'issue du traitement thermique de l'étape (c).

Plus particulièrement, les nanocristaux de composition (I) fonctionnalisés en surface par ledit ligand organique L1 peuvent être récupérés directement après l'étape (c) ou ils peuvent être soumis à une ou plusieurs étapes ultérieures pour former des nanoparticules de structure coeur/coquille.

Comme évoqué précédemment, selon une variante de réalisation, les nanoparticules considérées selon l'invention sont formées d'un nanocristal de composition (I), par exemple d'un nanocristal de ZAIS.

Les nanocristaux fonctionnalisés en surface par le ligand organique L1, par exemple par une amine telle que l' oleylamine, peuvent être récupérés dans une étape ultérieure (d) du procédé de synthèse décrit ci-dessus par centrifugation du milieu réactionnel obtenu à l'issue du traitement thermique de l'étape (c), et précipitation des nanocristaux par exemple à l'aide de méthanol.

Ces nanocristaux peuvent être redispersés dans le chloroforme pour former une suspension colloïdale stable.

Selon une autre variante de réalisation évoquée précédemment, les nanoparticules peuvent présenter une structure de type coeur/coquille, le coeur étant formé d'un nanocristal de composition (I) et la coquille étant en un composé semi-conducteur.

De telles nanoparticules de structure coeur/coquille peuvent être obtenues en formant, en surface des nanocristaux de composition (I), par exemple des nanocristaux de ZAIS, préparés comme décrit précédemment, une coquille en semi-conducteur, par exemple en ZnS.

Les nanoparticules de structure coeur/coquille, le coeur étant formé d'un nanocristal de composition (I) et la coquille en un alliage conducteur, peuvent être plus particulièrement préparées *via* au moins les étapes consistant en :

(i) disposer de nanocristaux de composition (I), par exemple de nanocristaux de ZAIS, dispersés dans le ligand organique L1, notamment une amine telle que l'oleylamine, à l'état liquide ;
(ii) ajouter à ladite dispersion de nanocristaux au moins un précurseur du ou des éléments du groupe I, II ou III et au moins un précurseur du ou des éléments du groupe V ou VI ;
(iii) soumettre la dispersion ainsi formée à un traitement thermique propice à la formation d'un revêtement de composé semi-conducteur en surface des nanocristaux ; et
(iv) récupérer les nanoparticules de structure coeur/coquille fonctionnalisées en surface par ledit ligand organique L1.

La dispersion de nanocristaux de composition (I), par exemple de nanocristaux de ZAIS, en étape (i) est plus particulièrement obtenue à l'issue de l'étape (c) du procédé de préparation des nanocristaux décrit précédemment.

Les précurseurs du ou des éléments du groupe I, II ou III et du ou des éléments du groupe V ou VI sont choisis de manière adéquate au regard de la nature de la coquille en semi-conducteur souhaitée.

A titre d'exemple, pour la formation d'une coquille en ZnS, la dispersion des nanocristaux peut être supplémentée en étape (ii) par de l'acétate de zinc et du thioacétamide.

Le traitement thermique pour former le revêtement en composé semi-conducteur, en particulier en ZnS, peut être opéré, sous atmosphère inerte, par exemple d'azote ou d'argon, à une température comprise entre 100 et 250 °C, en particulier entre 130 et 180 °C.

La durée du traitement thermique peut être par exemple comprise entre 1 et 30 minutes.

Comme décrit précédemment, les nanoparticules de structure coeur/coquille fonctionnalisées en surface par le ligand organique L1, par exemple par une amine telle que l'oleylamine, peuvent être récupérées en étape (iv) par précipitation dans le méthanol.

Ces nanoparticules peuvent être redispersées dans le chloroforme pour former une suspension colloïdale stable.

Ainsi, selon un mode de réalisation particulier, les nanoparticules fonctionnalisés en surface par au moins un ligand organique L1 en étape (1) du procédé selon l'invention peuvent être préparées *via* un procédé comprenant au moins, voire consistant en, les étapes consistant en :

(a1) disposer, à température ambiante, d'une poudre de précurseur de composition $Ag_xM_yM'_z(S_2CN(C_2H_5)_2)_{x+2y+3z}$,

avec M, M', x, y et z étant tels que définis précédemment ;

(a2) disperser à température ambiante ladite poudre de précurseur dans un ligand organique L1 à l'état liquide ;

(a3) soumettre la dispersion obtenue en étape (a2) à un traitement thermique, sous atmosphère inerte, par exemple sous atmosphère d'argon, à une température comprise entre 100 °C et 250 °C, pour obtenir lesdits nanocristaux de composition (I) ;

(a4) éventuellement, former à la surface des nanocristaux obtenus à l'issue de l'étape (a3), un revêtement en composé semi-conducteur ; et

(a5) récupérer les nanoparticules formées d'un nanocristal de composition (I) fonctionnalisé en surface par ledit ligand organique L1 qui sont obtenues à l'issue de l'étape (a3), ou les nanoparticules de structure coeur/coquille, avec le coeur formé du nanocristal de composition (I) et la coquille formée dudit composé semi-conducteur, et fonctionnalisées en surface par ledit ligand organique L1, obtenues à l'issue de l'étape (a4).

Comme mentionné ci-dessus, ledit procédé ne comprend aucune étape de prétraitement thermique avant le traitement thermique opéré en étape (a3) sur la dispersion dudit précurseur dans le ligand organique L1.

L'étape (a4) comprend plus particulièrement les étapes d'ajout à ladite dispersion de nanocristaux d'au moins un précurseur du ou des éléments du groupe I, II ou III et au moins un précurseur du ou des éléments du groupe V ou VI ; et de soumission de la dispersion ainsi formée à un traitement thermique propice à la formation d'un revêtement de composé semi-conducteur en surface des nanocristaux.

## Etape (2) : ECHANGE DE LIGANDS PAR UN LIGAND PHOSPHINE

Dans une seconde étape du procédé de l'invention, il est procédé à un échange, au moins en partie, des ligands organiques L1, par exemple de type amine, par des ligands de type phosphine, notés L2 dans la suite du texte, de formule générale :

$$PR_3 \qquad (II),$$

ou sa forme oxydée

$$O{=}PR_3 \qquad (II'),$$

les groupes R, identiques ou différents, représentant l'hydrogène, un groupe alkyle ou un groupe cycloalkyle, lesdits groupes alkyle ou cycloalkyle étant éventuellement substitués.

Dans le cadre de l'invention, on entend par :

- alkyle, un groupe aliphatique saturé, linéaire ou ramifié, en particulier présentant de 1 à 20 atomes de carbone, de préférence de 2 à 10 atomes de carbones ; et
- cycloalkyle, un groupe alkyle cyclique, en particulier présentant de 3 à 7 atomes de carbone, de préférence un groupe hexyle.

Les groupes alkyle et cycloalkyle peuvent être éventuellement substitués.

A titre d'exemple, ils peuvent être substitués par un ou plusieurs groupements -COOH.

D'autres substitutions sont envisageables, notamment pour apporter une fonctionnalité supplémentaire, par exemple par un ou plusieurs groupements choisis parmi un atome d'halogène, $-Si(OR^1)_3$ avec $R^1$ représentant un atome d'hydrogène ou un groupe alkyle, -SH, -OCN ; ou encore pour accroître l'effet donneur d'électrons des groupements R sur l'atome de phosphore, par exemple par un ou plusieurs groupements choisis parmi-$OR^2$, $-N(R^3)_2$, $-NHCOR^4$, $-CH{=}C(R^5)_2$, les groupes $R^2$, $R^3$, $R^4$ et $R^5$ pouvant être choisis indépendamment les uns des autres parmi l'hydrogène et un groupe alkyle.

Les ligands L2 de type phosphine selon l'invention peuvent être plus particulièrement choisis parmi les composés suivants :

- la trioctylphophine et sa forme oxydée, l'oxyde de trioctylphosphine

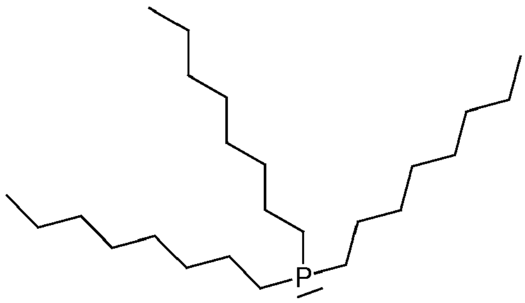

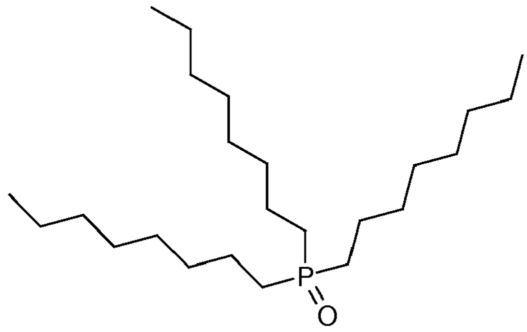

- la tricyclohexylphosphine

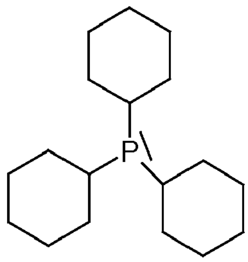

- la tri(2-carboxyéthyl)phosphine

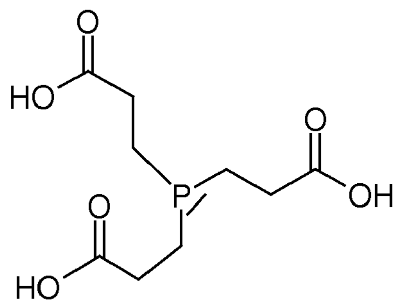

- la tri-tert-butylphosphine

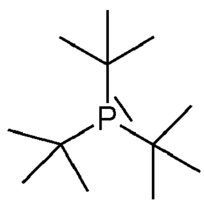

- la tributylphosphine

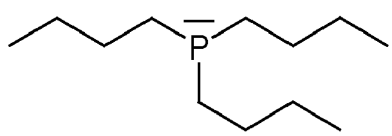

De préférence, on privilégie selon l'invention des phosphines ayant un faible encombrement stérique et possédant un ou plusieurs groupements R présentant un effet inductif donneur d'électrons important.

Selon un mode de réalisation particulièrement préféré, le ligand phosphine L2 est choisi parmi la tri(2-carboxyéthyl)phosphine, la tri-tert-butylphosphine, la trioctylphosphine et la tributylphosphine.
De préférence, le ligand phosphine L2 est la trioctylphosphine ou la tubutylphosphine.
Selon une variante de réalisation, le ligand phosphine L2 est la tubutylphosphine.
Selon une autre variante de réalisation particulièrement préférée, le ligand phosphine L2 est la trioctylphosphine.
L'échange des ligands en étape (2) du procédé de l'invention peut être opéré *via* au moins les étapes consistant en :

- disperser les nanoparticules préparées en étape (1) dans un solvant organique dans lequel est soluble le composé ligand L2 de type phosphine ;
- ajouter à ladite dispersion ledit composé ligand L2 de type phosphine, de préférence à température ambiante ; et
- laisser en contact lesdites nanoparticules et ledit composé ligand L2 de type phosphine, de préférence sous agitation, pendant une durée suffisante pour réaliser à la surface des nanoparticules, un échange, au moins en partie, des ligands organiques L1, par exemple oleylamine, par lesdits ligands L2 de type phosphine.

Le solvant organique de dispersion des nanoparticules peut être plus particulièrement le chloroforme.
L'échange des ligands peut être opéré en quelques minutes pour conduire aux nanoparticules selon l'invention fonctionnalisées en surface par les ligands spécifiques L2 de type phosphine.
L'homme du métier est à même d'ajuster la quantité de ligand L2 de type phosphine à ajouter à la dispersion de nanoparticules et la durée de mise en contact, au regard notamment de la nature du ligand L2 de type phosphine mis en oeuvre, afin d'obtenir l'échange de ligands souhaité.
Selon un autre de ses aspects, l'invention vise encore des nanoparticules formées en tout ou partie d'un nanocristal dont la composition chimique répond à la formule $Ag_xM_yM'_zS_{0,5x+y+1,5z}$ (I), dans laquelle M, M', x, y et z sont tels que définis précédemment, et fonctionnalisées en surface par un ligand de type phosphine L2 de formule générale $PR_3$ (II), ou sa forme oxydée $O{=}PR_3$ (II'), R étant tel que défini précédemment.
En particulier, il s'agit de nanoparticules formées en tout ou partie d'un nanocristal de ZAIS et fonctionnalisées en surface par un ligand de type phosphine L2.
Les nanoparticules peuvent être plus particulièrement obtenues selon le procédé décrit précédemment.
En particulier, le nanocristal de composition (I), par exemple le nanocristal de ZAIS, des nanoparticules selon l'invention est de préférence préparé selon le procédé original décrit précédemment.
Les nanoparticules fonctionnalisées en surface par lesdits ligands L2 de type phosphine peuvent présenter une taille moyenne comprise entre 3 et 40 nm, en particulier entre 5 et 10 nm.
La taille moyenne des nanoparticules selon l'invention peut être déterminée par microscopie électronique, en particulier par microscopie électronique à transmission, et plus particulièrement par microscopie électronique à transmission haute résolution (HRTEM) ou microscopie électronique à balayage par transmission (STEM).
Selon un mode de réalisation particulier, les nanoparticules selon l'invention se présentent sous la forme d'une solution colloïdale. Une telle solution colloïdale peut être obtenue par suspension desdites nanoparticules dans un solvant organique, en particulier le chloroforme.
Les nanoparticules selon l'invention, notamment les nanoparticules à base de ZAIS, présentent, sous excitation dans le domaine spectral, un maximum d'émission dans la gamme de longueurs d'onde comprise entre 550 nm et 850 nm, variant selon la composition du nanocristal, et plus particulièrement de la composition du précurseur mis en oeuvre pour sa préparation. Elles présentent avantageusement une bande d'émission large (de 100 à 150 nm).

## APPLICATIONS

Comme évoqué précédemment, les nanoparticules selon l'invention peuvent être mises en oeuvre à titre de matériau photoluminescent pour des applications diverses, par exemple à titre de traceur en biologie ou dans des dispositifs électroluminescents, par exemple comme luminophore dans une diode électroluminescente.
L'invention concerne ainsi, selon un autre de ses aspects, l'utilisation des nanoparticules de l'invention, à titre de traceur en biologie ou de luminophore dans une diode électroluminescente.
Selon une variante de réalisation particulièrement avantageuse, les nanoparticules selon l'invention sont mises en oeuvre pour former le luminophore d'une diode électroluminescente blanche.
La mise en oeuvre des nanoparticules selon l'invention dans ce type de dispositifs relève de techniques connues de l'homme du métier.
Selon encore un autre de ses aspects, la présente invention concerne un dispositif électroluminescent, en particulier une diode électroluminescente, et plus particulièrement une diode électroluminescente blanche, contenant un phosphore à base de nanoparticules selon l'invention.
Bien entendu, l'invention n'est pas limitée aux dispositifs évoqués ci-dessus, et d'autres applications des nanoparticules fonctionnalisées selon l'invention peuvent être envisagées.

L'invention va maintenant être décrite au moyen d'exemples et figures suivants donnés à titre illustratif et non limitatif de l'invention.

## Figures

Figure 1 : Représentation schématique de l'échange des ligands oleylamine par des ligands trioctylphosphine en surface des nanocristaux de ZAIS selon le procédé de l'invention ;

Figure 2 : Rendement quantique interne obtenu pour la longueur d'onde correspondant au maximum d'émission pour des nanocristaux de ZAIS, préparés à partir de différentes compositions de précurseurs selon le procédé décrit par Torimoto et al. [1], sans échange de ligands (-■-) et après échange des ligands oleylamine par des ligands trioctylphosphine (-●-) ;

Figure 3 : Rendement quantique interne obtenu pour la longueur d'onde correspondant au maximum d'émission pour des nanocristaux de ZAIS, préparés à partir de différentes compositions de précurseurs selon le procédé original de l'exemple 2, sans échange de ligands (-■-) et après échange des ligands oleylamine par des ligands trioctylphosphine selon l'invention (-●-).

## EXEMPLES

### EXEMPLE 1 -Synthèse de la poudre de précurseur $Ag_xZn_yIn_z(S_2CN(C_2H_5)_2)_{x+2y+3z}$

Une poudre de précurseur $(AgIn)_nZn_{2(1-n)}(S_2CN(C_2H_5)_2)_4$ est préparée comme suit.

n moles d'$AgNO_3$, n moles d'$In(NO_3)_3$ et 2-2n moles de $Zn(NO_3)_2$ sont dissous dans 250 mL d'eau DI (solution S1). La quantité totale de charges positives provenant des ions $Ag^+$, $In^{3+}$ et $Zn^{2+}$ introduits est fixée à 12,5 mmol. 5,6328 g (25 mmol) de diéthyldithiocarbamate de sodium sont dissous à part dans 250 mL d'eau DI (solution S2). Une fois que les deux solutions sont bien homogènes, la solution S1 est ajoutée lentement à la solution S2 sous agitation. Un précipité jaune pâle se forme immédiatement. La solution est alors laissée sous agitation pendant au moins 3 jours. La couleur du précipité change progressivement du jaune pâle au bleu.

Le précipité est récupéré par centrifugation de la solution puis lavé 3 fois avec 250 mL d'eau DI et une fois avec 50 mL de méthanol. Le précipité est ensuite séché à l'air libre avant utilisation.

### EXEMPLE 2 - Synthèse des nanocristaux de ZAIS

300 mg de précurseur préparé comme décrit en exemple 1 sont dispersés dans 9 mL d'oleylamine préalablement distillée. La solution est ensuite introduite dans un ballon en verre sous agitation et sous argon. Après dégazage de la solution sous argon pendant 15 minutes à température ambiante, le ballon est introduit dans un bain de chauffage à une température de 180 °C. La solution devient alors très rapidement sombre et est laissée sous agitation et sous argon pendant 20 minutes. Après ces 20 minutes, la solution est vite refroidie à température ambiante puis placée dans des tubes afin de procéder à sa purification.

Le brut de synthèse contient des nanocristaux de ZAIS (tétragonal) ainsi que des particules plus grosses d'$Ag_2S$ et d'$Ag_xZn_yIn_zS_{0,5x+y+1,5z}$ orthorhombique dispersés dans l'oleylamine. La solution est centrifugée deux fois afin de ne récupérer que les particules nanométriques de ZAIS restées en suspension. La solution d'oleylamine contenant les nanocristaux est alors limpide.

Cette solution est ensuite introduite dans 35 mL de méthanol afin de faire floculer les nanocristaux. Le mélange est centrifugé afin de ne récupérer que les nanocristaux floculés, tombés au fond, tandis que l'oleylamine excédentaire est éliminée avec le surnageant. 5 mL environ de chloroforme sont ajoutés sur les nanocristaux afin de les disperser. La solution obtenue est alors limpide indiquant une bonne stabilité colloïdale des nanocristaux dans le chloroforme.

### EXEMPLE 3 - Synthèse des nanoparticules coeur (nanocristal de ZAIS)/coquille (ZnS)

300 mg de précurseur préparé comme décrit en exemple 1 sont dispersés dans 9 mL d'oleylamine préalablement distillée. La solution est ensuite introduite dans un ballon en verre sous agitation et sous argon. Après dégazage de la solution sous argon pendant 15 minutes à température ambiante, le ballon est introduit dans un bain de chauffage à une température de 180 °C. La solution devient alors très rapidement noire et est laissée sous agitation et sous argon pendant 20 minutes dans ces conditions. Après ces 20 minutes, la solution est vite refroidie à température ambiante puis placée dans des tubes afin de procéder à sa purification.

Afin d'éliminer les particules non voulues, la solution est centrifugée deux fois afin de ne récupérer que les particules nanométriques restées en suspension. La solution d'oleylamine contenant les nanocristaux est alors limpide. Cette solution est ensuite introduite dans un nouveau ballon en verre, sous agitation et sous argon.

A part, 70 mg d'acétate de zinc et 30 mg de thioacétamide sont dissous séparément dans 2,5 mL d'oleylamine distillée. Après dilution complète, les deux solutions sont mélangées (solution S3). Après dégazage de la solution de nanocristaux (15 minutes sous argon), le ballon est introduit dans un bain de chauffage à 140 °C. Une minute après le début du chauffage, la solution S3 est ajoutée goutte à goutte dans le ballon. L'ajout est effectué en 2 minutes et la réaction est laissée à 140 °C pour encore 2 minutes supplémentaires (temps total de chauffage : 5 minutes). La solution est ensuite rapidement refroidie à température ambiante avant d'éliminer l'oleylamine excédentaire et de disperser les nanocristaux.

Pour cela, la solution est ensuite introduite dans 35 mL de méthanol afin de faire floculer les nanocristaux. Le mélange est centrifugé afin de ne récupérer que les nanocristaux floculés, tombés au fond, tandis que l'oleylamine excédentaire est éliminée avec le surnageant. 5 mL environ de chloroforme sont ajoutés sur les nanocristaux afin de les disperser.

**EXEMPLE 4 - Echange de ligand avec un dérivé de type phosphine**

Une fois la solution de nanocristaux de ZAIS ou de nanoparticules coeur (nanocristal ZAIS)/écorce (ZnS), obtenue dans le chloroforme, comme décrit dans les exemples 2 et 3, quelques gouttes (100 µL) de trioctylphosphine ou d'un autre dérivé de type phosphine sont ajoutées à la solution. La solution est ensuite agitée.

Les mesures de photoluminescence sont réalisées à l'aide d'un spectromètre de rendement quantique absolu (Hamamatsu Quantaurus - QY C11347).

Une augmentation de la photoluminescence des nanoparticules sous excitation UV est observée très rapidement (en moins d'une minute).

**EXEMPLE 5 - Augmentation du rendement quantique par la fonctionnalisation par un composé ligand de type phosphine**

Effet de la modification de surface par la trioctylphosphine de nanocristaux ZAIS synthétisés selon Torimoto *et al.* [1] et selon le procédé de l'exemple 2

L'effet de la fonctionnalisation de surface de nanocristaux par des ligands trioctylphosphine sur le rendement quantique interne a été évalué, d'une part pour des nanocristaux préparés selon le procédé décrit par Torimoto *et al.* [1] et, d'autre part, pour des nanocristaux préparés selon le procédé original décrit en exemple 2, pour différentes compositions de précurseur $(AgIn)_nZn_{2(1-n)}(S_2CN(C_2H_5)_2)_4$ utilisé.

Les rendements quantiques internes de photoluminescence ont été déterminés avec le spectromètre de rendement quantique absolu (Hamamatsu Quantaurus - QY C11347), comportant une sphère d'intégration sur mesure.

Pour chaque nanocristal, le rendement quantique interne ( %) est évalué pour la longueur d'onde correspondant au maximum d'émission du nanocristal.

La figure 2 représente les données de rendement quantique interne obtenu pour la longueur d'onde du pic de photoluminescence obtenu pour chaque nanocristal préparé selon le procédé décrit par Torimoto *et al.* [1], sans échange de ligands (-■-) et après échange des ligands oleylamine par des ligands trioctylphosphine (-●-). (Le traitement de surface par la trioctylphosphine n'a été appliqué que pour certains nanocristaux synthétisés avec le procédé décrit par Torimoto *et al.* [1].

L'échange de ligands a été opéré comme décrit dans l'exemple 4 à partir de nanocristaux de ZAIS obtenus selon le procédé décrit par Torimoto *et al.* [1].

De même, la figure 3 représente les données de rendement quantique obtenu pour la longueur d'onde du pic de photoluminescence obtenu pour chaque nanocristal préparé selon le procédé original de l'exemple 2, sans échange de ligands (-■-) et après échange des ligands oleylamine par des ligands trioctylphosphine conformément à l'exemple 4 (-●-).

Les étiquette (« 0,4 », « 0,5 », etc.) figurant sur les graphes précisent la donnée « n » de la composition du précurseur utilisé pour la synthèse du nanocristal de ZAIS.

Il ressort des figures 2 et 3 que la fonctionnalisation des nanocristaux de ZAIS par le ligand de type phosphine (trioctylphosphine), permet d'améliorer le rendement quantique interne de photoluminescence du nanocristal de ZAIS, et ce quel que soit leur mode de préparation.

De manière avantageuse, cette amélioration du RQI est exacerbée dans le cas des nanocristaux préparés selon le procédé original de l'exemple 2, comparativement à ceux obtenues selon le protocole de synthèse connu de la publication [1].

Effet de la modification de surface par différents ligands de type phosphine

Le tableau 1 suivant regroupe les valeurs de RQI (efficacité totale obtenue sur l'ensemble du spectre d'émission pour une longueur d'onde d'excitation de 510 nm), obtenu après échange des ligands oleylamine de nanocristaux de ZAIS synthétisés selon l'exemple 2 (n de la composition de précurseur valant 0,7) avec les dérivés de type phosphine listés dans le tableau 1, conformément à l'exemple 4.

Entre parenthèses, est indiquée la valeur de l'augmentation de RQI par rapport à la valeur de référence de RQI obtenu avec une fonctionnalisation en surface par l'oleylamine.

**TABLEAU 1**

| **Ligands de fonctionnalisation** | **RQI** (%) |
|---|---|
| Oleylamine (fin de synthèse, référence) | 41 |
| Acide orthophosphonique (*non conforme)* | 31 (-10) |
| Triphénylphosphine *(non conforme)* | 32 (-9) |
| Tricyclohexylphosphine | 44 (+3) |
| Tri(2-carboxyethyl)phosphine | 49 (+8) |
| Tri-tert-butylphosphine | 52 (+11) |
| Trioctylphosphine | 54 (+13) |
| Tributylphosphine | 60 (+19) |

Pour remarque, les valeurs obtenues sont différentes, mais l'évolution des RQI avec les différents ligands de fonctionnalisation reste identique pour d'autres longueurs d'onde d'excitation, et en particulier à une longueur d'onde de 450 nm.

Les résultats obtenus montrent que les nanocristaux fonctionnalisés avec des ligands de type phosphine conformes à l'invention permettent d'améliorer le RQI des nanocristaux de ZAIS.

Références

[1] Torimoto et al., Facile Synthesis of ZnS-AgInS2 Solide Solution Nanoparticules for a Color-Adjustable Luminophore, J. Am. Chem. Soc. 129, 12388-12389 (2007) ;

[2] WO 2013/162334 ;

[3] KR 2013-0095603 ;

[4] Torimoto et al., Remarkable photoluminescence enhancement of ZnS-AgInS2 solid solution nanoparticules by post-synthesis treatment, Chem. Commun. 46, 2082 (2010) ;

[5] Mao et al., Study of the Partial Ag-to-Zn Cation Exchange in AgInS2/ZnS Nanocrystals, J. Phys. Chem., C117, 648-656 (2013) ;

[6] Krause et al., P. Chemical and Thermodynamic Control of the Surface of Semiconductor Nanocrystals for Designer White Light Emitters, ACS Nano 7, 5922-5929 (2013).


## Revendications

**1.** Procédé pour augmenter le rendement quantique interne de photoluminescence de nanoparticules formées au moins en partie d'un nanocristal de type $Ag_xM_yM'_zS_{0,5x+y+1,5z}$, comprenant au moins les étapes consistant en :

(1) disposer de nanoparticules formées en tout ou partie d'un nanocristal dont la composition chimique répond à la formule (I) :

$$Ag_xM_yM'_zS_{0,5x+y+1,5z} \qquad (I)$$

dans laquelle :

M est choisi parmi le zinc, le cadmium, le mercure et leurs mélanges ;
M' est choisi parmi l'aluminium, le gallium, l'indium, le thallium et leurs mélanges ;

$$0 < x \leq 1 \; ; 0 \leq y \leq 1 \text{ et } 0 < z \leq 1 \; ;$$

lesdites nanoparticules étant fonctionnalisées en surface par au moins un ligand organique L1 différent d'un ligand de type phosphine ;
lesdits nanocristaux de composition chimique de formule (I) étant préalablement préparés *via* un procédé comprenant au moins les étapes consistant en :

(a) disposer d'une poudre de précurseur de composition $Ag_xM_yM'_z(S_2CN(C_2H_5)_2)_{x+2y+3z}$, avec M, M', x, y et z étant tels que définis ci-dessus ;
(b) disperser ladite poudre de précurseur dans le ligand organique L1 à l'état liquide ; et
(c) soumettre la dispersion obtenue en étape (b) à un traitement thermique, sous atmosphère inerte, à une température comprise entre 100 °C et 250 °C, pour obtenir lesdits nanocristaux de composition chimique de formule (I),

ledit procédé de préparation des nanocristaux mettant en oeuvre une unique étape de traitement thermique consistant en l'étape (c) ;
et
(2) mettre en présence lesdites nanoparticules avec au moins un composé ligand L2 de type phosphine de formule générale :

$PR_3$ (II),

ou sa forme oxydée

$O{=}PR_3$ (II'),

chacun des groupes R, identiques ou différents, étant choisi parmi l'hydrogène, un groupe alkyle et un groupe cycloalkyle, lesdits groupes alkyle et cycloalkyle étant éventuellement substitués ;
dans des conditions propices à un échange, au moins en partie, des ligands organiques L1 par lesdits ligands de type phosphine L2.

2. Procédé selon la revendication 1, dans lequel les nanoparticules sont formées en tout ou partie d'un nanocristal dont la composition chimique répond à la formule (I) dans laquelle M représente le zinc et M' représente l'indium.

3. Procédé selon la revendication 1 ou 2, dans lequel les nanoparticules en étape (1) sont formées en tout ou partie d'un nanocristal constitué d'une solution solide de type $Ag_xZn_yIn_zS_{0,5x+y+1,5z}$ (I'), dans laquelle x, y et z varient entre 0 et 1, x, y et z étant tous différents de zéro.

4. Procédé selon l'une quelconque des revendications précédentes, dans lequel le ligand organique L1 de fonctionnalisation des nanoparticules en étape (1) est choisi parmi les amines comprenant au moins une chaîne hydrocarbonée linéaire ou ramifiée, saturée ou insaturée, comportant au moins 8 atomes de carbone, en particulier est l'oleylamine.

5. Procédé selon l'une quelconque des revendications précédentes, dans lequel le traitement thermique en étape (c) est opéré à une température d'environ 180 °C, en particulier pendant une durée allant de 3 minutes à 4 heures, notamment de 20 minutes à 30 minutes.

6. Procédé selon l'une quelconque des revendications précédentes, dans lequel les nanoparticules sont des nanocristaux dont la composition chimique répond à la formule (I) telle que définie selon l'une quelconque des revendications 1 à 3.

7. Procédé selon l'une quelconque des revendications 1 à 5, dans lequel les nanoparticules présentent une structure de type coeur/coquille, le coeur étant un nanocristal de composition (I) telle que définie selon l'une quelconque des

revendications 1 à 3 ; et la coquille étant constituée d'un composé semi-conducteur, en particulier choisi parmi les alliages semi-conducteurs binaires, ternaires ou quaternaires formés d'un ou plusieurs élément(s) du groupe I, II ou III et d'un ou plusieurs élément(s) du groupe V ou VI, tels que ZnS, ZnSe, CdS, A1P, GaP, $Al_2S_3$ et $Ga_2S_3$.

**8.** Procédé selon la revendication précédente, dans lequel la coquille desdites nanoparticules est en ZnS.

**9.** Procédé selon la revendication 7 ou 8, dans lequel les nanoparticules de structure coeur/coquille en étape (1) sont préparées *via* au moins les étapes consistant en :

(i) disposer de nanocristaux de composition chimique de formule (I), dispersés dans le ligand organique L1 à l'état liquide, ladite dispersion étant obtenue à l'issue de l'étape (c) ;
(ii) ajouter à ladite dispersion de nanocristaux au moins un précurseur du ou des éléments du groupe I, II ou III et au moins un précurseur du ou des éléments du groupe V ou VI ;
(iii) soumettre la dispersion ainsi formée à un traitement thermique propice à la formation d'un revêtement de composé semi-conducteur, en particulier de ZnS, en surface des nanocristaux ; et
(iv) récupérer les nanoparticules de structure coeur/coquille fonctionnalisées en surface par ledit ligand organique L1.

**10.** Procédé selon la revendication précédente, pour la préparation de nanoparticules de structure coeur/coquille, la coquille étant en ZnS, dans lequel la dispersion de nanocristaux est supplémentée en étape (ii) par de l'acétate de zinc et du thioacétamide.

**11.** Procédé selon l'une quelconque des revendications précédentes, dans lequel le ligand L2 de type phosphine en étape (2) est choisi parmi la trioctylphosphine, l'oxyde de trioctylphosphine, la tricyclohexylphosphine, la tri(2-carboxyéthyl)phosphine, la tri-tert-butylphosphine et la tributylphosphine, en particulier parmi la trioctylphosphine et la tributylphosphine, de préférence la trioctylphosphine.

**12.** Procédé selon l'une quelconque des revendications précédentes, dans lequel l'étape (2) d'échange des ligands est opérée *via* au moins les étapes consistant en :

- disperser les nanoparticules de l'étape (1) dans un solvant organique dans lequel est soluble le composé ligand L2 de type phosphine, en particulier dans le chloroforme ;
- ajouter à ladite dispersion ledit composé ligand L2 de type phosphine, de préférence à température ambiante ; et
- laisser en contact lesdites nanoparticules et ledit composé ligand L2 de type phosphine, de préférence sous agitation, pendant une durée suffisante pour réaliser à la surface des nanoparticules un échange, au moins en partie, des ligands organiques L1, en particulier l'oleylamine, par lesdits ligands L2 de type phosphine.

**13.** Nanoparticules formées en tout ou partie d'un nanocristal dont la composition chimique répond à la formule

$$Ag_xM_yM'_zS_{0,5x+y+1,5z} \qquad (I)$$

dans laquelle M, M', x, y et z sont tels que définis selon l'une quelconque des revendications 1 à 3, lesdites nanoparticules étant fonctionnalisées en surface par un ligand L2 de type phosphine tel que défini selon la revendication 1 ou 11, lesdites nanoparticules étant obtenues selon le procédé tel que défini selon l'une quelconque des revendications 1 à 12.

**14.** Utilisation des nanoparticules telles que définies en revendication 13, à titre de traceur en biologie ou de luminophore dans une diode électroluminescente.

**15.** Utilisation selon la revendication précédente des nanoparticules pour former le luminophore d'une diode électroluminescente blanche.

**16.** Dispositif électroluminescent, en particulier diode électroluminescente, et plus particulièrement diode électroluminescente blanche, contenant un phosphore à base de nanoparticules telles que définies en revendication 13.

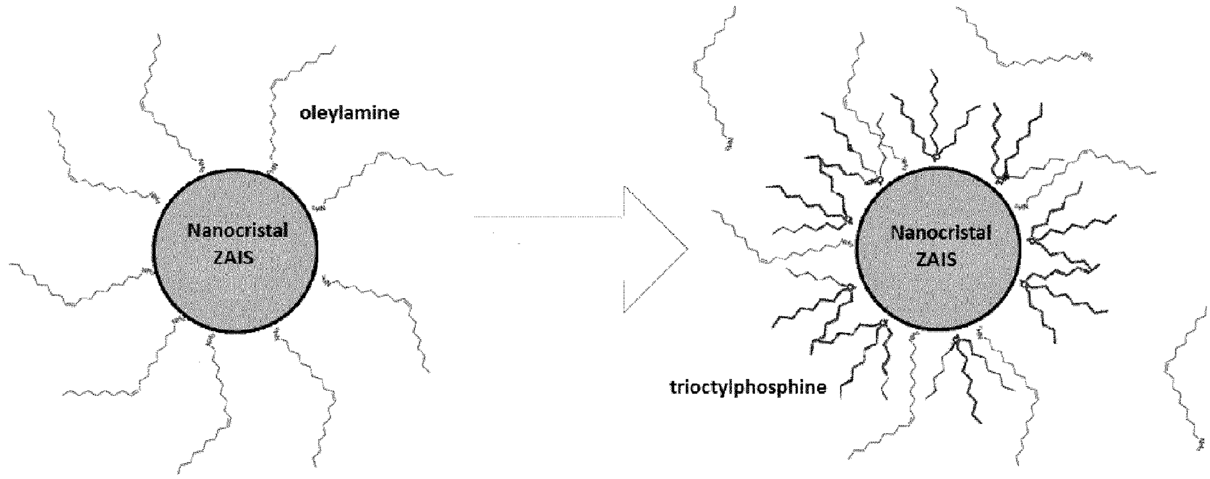


FIGURE 1

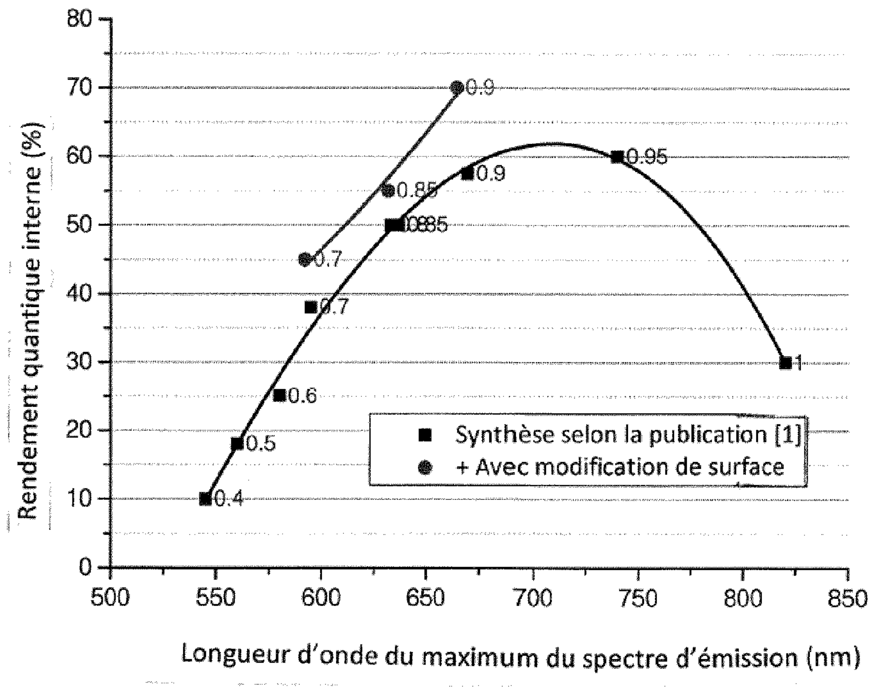


FIGURE 2

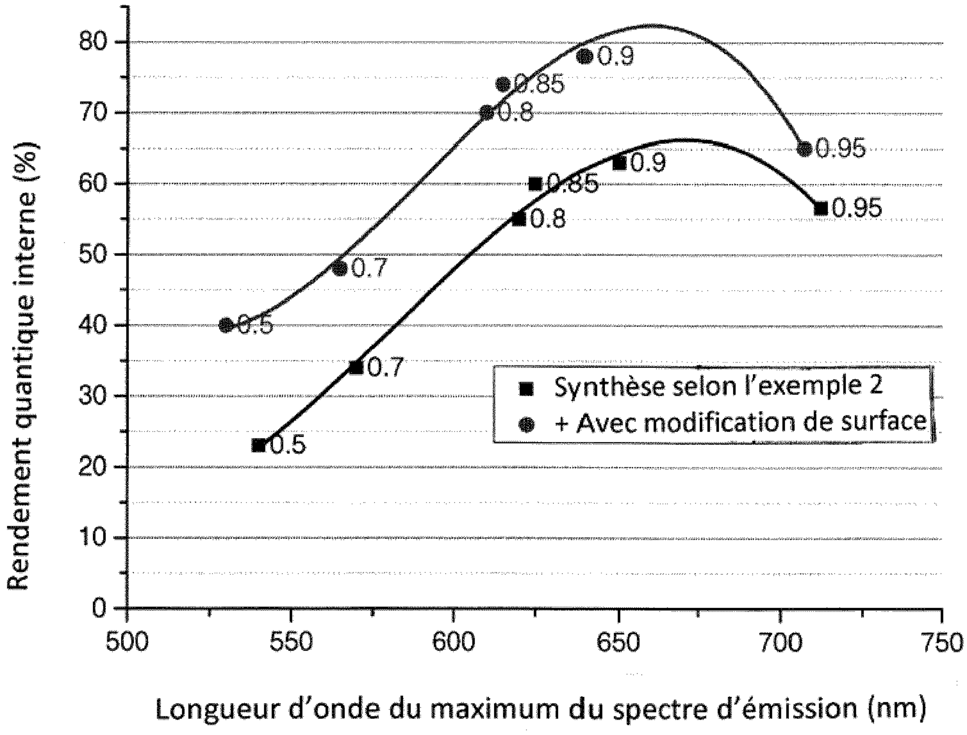
Rendement quantique interne (%)
0
10
20
30
40
50
60
70
80
500
550
600
650
700
750
Longueur d'onde du maximum du spectre d'émission (nm)
Synthèse selon l'exemple 2
+ Avec modification de surface
0.5
0.7
0.8
0.85
0.9
0.95

**FIGURE 3**

Europäisches Patentamt
European Patent Office
Office européen des brevets

# RAPPORT DE RECHERCHE EUROPEENNE

Numéro de la demande
EP 16 16 1548

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | JP 2014 169421 A (KANEKA CORP; UNIV OSAKA) 18 septembre 2014 (2014-09-18)<br>* alinéas [0029], [0030], [0032], [0034]; revendications; exemples *<br>----- | 1-16 | INV.<br>C09K11/02<br>C09K11/62<br>C09K11/58 |
| X | US 2007/096128 A1 (FUKUDOME MASATO [JP] ET AL) 3 mai 2007 (2007-05-03)<br>* alinéas [0003], [0068], [0069], [0080]; revendications 3,5,12-14; tableau 1 *<br>----- | 1-16 | |
| A | DATABASE WPI<br>Week 201381<br>28 août 2013 (2013-08-28)<br>Thomson Scientific, London, GB;<br>AN 2013-V25228<br>XP002753452,<br>-& CN 103 265 948 A (UNIV WENZHOU)<br>28 août 2013 (2013-08-28)<br>* abrégé; revendications *<br>----- | 1-16 | |
| | | | DOMAINES TECHNIQUES RECHERCHES (IPC) |
| A | TATSUYA KAMEYAMA ET AL:<br>"Photoluminescence Enhancement of ZnS-AgInS2 Solid Solution Nanoparticles Layer-by-layer-assembled in Inorganic Multilayer Thin Films",<br>CHEMISTRY LETTERS,<br>vol. 37, no. 7, 31 mai 2008 (2008-05-31), pages 700-701, XP055244909,<br>JAPAN<br>ISSN: 0366-7022, DOI: 10.1246/cl.2008.700<br>* page 700 *<br>----- | 1-16 | C09K<br>H01L |

1 Le présent rapport a été établi pour toutes les revendications

| Lieu de la recherche | Date d'achèvement de la recherche | Examinateur |
|---|---|---|
| La Haye | 16 août 2016 | Baldé, Kaisa |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
..................................................................
& : membre de la même famille, document correspondant

EPO FORM 1503 03.82 (P04C02)

# ANNEXE AU RAPPORT DE RECHERCHE EUROPEENNE RELATIF A LA DEMANDE DE BREVET EUROPEEN NO.

EP 16 16 1548

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

16-08-2016

| Document brevet cité au rapport de recherche | Date de publication | Membre(s) de la famille de brevet(s) | Date de publication |
|---|---|---|---|
| JP 2014169421 A | 18-09-2014 | AUCUN | |
| US 2007096128 A1 | 03-05-2007 | AUCUN | |
| CN 103265948 A | 28-08-2013 | AUCUN | |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- WO 2013162334 A
- KR 20130095603


### Littérature non-brevet citée dans la description


- **TORIMOTO et al.** Facile Synthesis of ZnS-AgInS2 Solide Solution Nanoparticules for a Color-Adjustable Luminophore. *J. Am. Chem. Soc.,* 2007, vol. 129, 12388-12389
- **TORIMOTO et al.** Remarkable photoluminescence enhancement of ZnS-AgInS2 solid solution nanoparticules by post-synthesis treatment. *Chem. Commun.,* 2010, vol. 46, 2082
- **MAO et al.** Study of the Partial Ag-to-Zn Cation Exchange in AgInS2/ZnS Nanocrystals. *J. Phys. Chem.,* 2013, vol. C117, 648-656
- **KRAUSE et al.** P. Chemical and Thermodynamic Control of the Surface of Semiconductor Nanocrystals for Designer White Light Emitters. *ACS Nano,* 2013, vol. 7, 5922-5929